Europäisches Patentamt

(19) European Patent Office

Office européen des brevets

(11) Numéro de publication: **0 265 315 B1**

(12) **FASCICULE DE BREVET EUROPEEN**

(45) Date de publication de fascicule du brevet:
25.09.91

(51) Int. Cl.⁵: **H03K 17/78,** H03K 17/687,
H03K 17/693

(21) Numéro de dépôt: **87402215.5**

(22) Date de dépôt: **06.10.87**

(54) **Commutateur électronique bistable integré à faible chute de tension.**

(30) Priorité: **08.10.86 FR 8614006**

(43) Date de publication de la demande:
**27.04.88 Bulletin 88/17**

(45) Mention de la délivrance du brevet:
**25.09.91 Bulletin 91/39**

(84) Etats contractants désignés:
**AT BE CH DE ES GB GR IT LI LU NL SE**

(56) Documents cités:
**US-A- 4 603 234**

**IBM TECHNICAL DISCLOSURE BULLETIN, vol. 26, no. 12, mai 1984, pages 6611-6613, New York, US; D.J. HUTSON: "High voltage switch"**

**IEEE ELECTRO, vol. 8, 1983, pages 7/3/1-7/3/9, New York, US; E.T. RODRIGUEZ: "Optically coupled power MOSFET technology: A monolithic replacement for electromechanical relays"**

(73) Titulaire: **AEROSPATIALE Société Nationale Industrielle
37, Boulevard de Montmorency
F-75781 Paris Cédex 16(FR)**

(72) Inventeur: **Prevost, Claude
15 Villepreux-Village St-Aubin-du Médoc
F-33160 St-Medard-En-Jalles(FR)**
Inventeur: **Le Bourhis, Gérard
7 allée des Hêtres
F-33160 St-Medard-En-Jalles(FR)**

(74) Mandataire: **Mongrédien, André et al
c/o SOCIETE DE PROTECTION DES INVEN-TIONS 25, rue de Ponthieu
F-75008 Paris(FR)**

ELEKTRONIK, vol. 32, no. 18, 9 septembre 1983, page 128, Munich, DE; R. OESTE-RHAUS: "Leistungs-FET potentialfrei anges-teuert"

MESURES - REGULATION - AUTOMATISME, vol. 41, no. 6, juin 1976, pages 45-61, Paris, FR; B. LORIFERNE: "Les composants utilises dans les convertisseurs"

MACHINE DESIGN, vol. 56, no. 24, 25 octobre 1984, pages 22-24,26, Cleveland, Ohio, US; B.H. CARLISLE: "Power integration techni-ques bring single-chip relays"

Description

La présente invention a pour objet un commutateur électronique bistable intégré à faible chute de tension dans le domaine des puissances moyennes, c'est-à-dire pour des commutations de l'ordre de 10A à 50A. Ce commutateur se présente sous la forme d'un composant électronique unique.

L'invention trouve une application dans tous les domaines où une commutation rapide sans rebondissement est requise, et dans les milieux où l'ambiance vibratoire est importante, notamment dans les aéronefs (avions, hélicoptères, satellites, ...) et autre appareils terrestres et navals.

L'invention se rapporte à des commutateurs électroniques bistables, monodirectionnels et bidirectionnels.

Un premier type de commutateur connu est constitué par les relais électromécaniques. Ces relais existent sous la forme de relais monostables et sous la forme de relais bistables, qui par opposition aux précédents peuvent rester en position sans consommer d'énergie. Les relais électromécaniques sont capables de commuter aussi bien des bas niveaux que des fortes puissances, ou de fonctionner en inverseur.

L'utilisation des relais électromécaniques est limitée à certaines applications du fait de leur lenteur. De plus, ils présentent des axes sensibles aux accélérations, ce qui rend leur utilisation délicate dans les mobiles tels que avions ou satellites. Enfin, de nombreux relais électromécaniques commutent avec des rebondissements.

On connaît un deuxième type de commutateur constitué par les commutateurs statiques. A l'inverse des relais électromécaniques, les relais statiques présentent une grande vitesse de commutation, sont insensibles aux accélérations, donc aux vibrations, et sont en général exempts de rebondissements.

Il existe deux types de commutateurs statiques : les relais statiques pour courant continu, ou relais statiques continus, et les relais statiques pour courant alternatif, ou relais statiques alternatifs.

Les relais statiques continus ne permettent pas la bistabilité et présentent une chute de tension importante aux bornes du circuit, de l'ordre de 1,5 volt à 2 volts. Quant aux relais statiques alternatifs, ils ne peuvent être utilisés qu'en alternatif car la recoupe est impossible en courant continu.

Des relais statiques sont décrits notamment dans les documents suivants :

a) FR-A-2 567 340 : le relais décrit est uniquement monostable et la charge ne peut être que dans le drain du transistor MOS de puissance constituant l'interrupteur (le transistor ne coupe donc que le potentiel bas en continu). De plus, la chute de tension est importante, car un shunt s'ajoute à la résistance passante $R_{on}$ du transistor MOS.

b) EP-A-0 164 770 : dans l'appareil décrit, il n'est pas prévu d'isolation électrique entre les moyens délivrant le signal de commande au commutateur et le transistor constituant l'interrupteur. Cet appareil est monostable et monodirectionnel et nécessite une alimentation auxiliaire. Enfin, la charge est obligatoirement dans l'émetteur du transistor et la chute de tension est importante.

c) EP-A-0 165 121 : ce document décrit un dispositif de commande pour un commutateur statique monostable. l'isolation entre la commande et l'utilisation est assurée par un transformateur, ce qui induit un encombrement important. Pour certaines configurations d'utilisation, il faut de plus une alimentation auxiliaire.

d) EP-A-0 166 390 : l'appareil décrit est monostable, ne fonctionne qu'en alternatif et ne comprend pas d'isolation entre la commande et l'utilisation. De plus, la chute de tension est importante.

e) US-A-4 571 513, US-A-4 553 151, US-A-4 551 643 et US-A-4 542 396 : ces documents se rapportent soit à des structures d'interrupteurs dont la commande n'est pas isolée complètement de l'utilisation, soit à des montages utilisant comme interrupteur des thyristors ou des optothyristors. Dans ce dernier cas, le commutateur ne peut travailler qu'en alternatif, la recoupe en continue étant impossible. Par ailleurs, la chute de tension aux bornes des appareils est importante.

Il est connu du document Modern Electronic Circuits Reference manual - 1980 de John Markus, page 958 "Latching SPDT", page 792 "Logic drives SCR" un commutateur électronique bistable intégré comportant un transistor MOS, un circuit de commande en technologie MOS comprenant une bascule munie d'une entrée de mise à "1" et d'une entrée de mise à "0", et d'au moins une sortie de commande reliée à la grille du transistor MOS.

Par le document IBM Technical Disclosure Bulletin, vol. 26, N° 12 - 1984, p. 6611-6613, "High voltage switch" de D.J. Hutson, il est connu un commutateur électronique comportant des transistors MOS, un circuit de commande, une source d'alimentation pour alimenter le circuit de commande et des coupleurs optiques pour recevoir chacun un signal électrique de commande de commutation et pour transmettre ledit signal sur une entrée du circuit de commande, ces coupleurs assurant un isolement électrique du commutateur. Ce commutateur n'est pas un commutateur bidirectionnel.

Par ailleurs, on connait par le document Machine Design, vol. 56, n° 24, octobre 1984, p. 22-24, 26, "Power integration techniques bring single-chip relays" de B.H. Carlisle un commutateur électronique comportant un interrupteur dont les bornes sont constituées par les drains de deux transistors de puissance connectés en série, un coupleur optique qui agit comme un moyen d'alimentation électrique et comme un moyen de commande de commutation. Ce commutateur n'est pas un commutateur bistable.

L'invention a notamment pour but de remédier aux inconvénients des commutateurs électromécaniques ou statiques connus. L'invention vise en particulier à lier les qualités des commutateurs électromécaniques, notamment une faible chute de tension aux bornes et la bistabilité, et les qualités des commutateurs statiques, notamment la rapidité de commutation et l'insensibilité aux vibrations.

De manière plus précise, l'invention a pour objet un commutateur électronique de puissance bidirectionnel et bistable, intégré tel · que défini dans la revendication 1.

Le commutateur de l'invention étant bidirectionnel, il peut donc être utilisé pour des signaux alternatifs.

Selon un mode préféré de réalisation, le commutateur de l'invention est agencé pour être du type repos-travail.

Dans chacun des modes de réalisation du commutateur bistable bidirectionnel de l'invention, la source d'alimentation intégrée peut être constituée par exemple de piles ou d'un condensateur. Dans ce dernier cas, des moyens sont prévus pour recharger ce condensateur.

Les caractéristiques et avantages de l'invention ressortiront mieux de la description qui va suivre, donnée à titre illustratif mais non limitatif, en référence aux dessins annexés, sur lesquels :
- la figure 1 illustre, de manière schématique, la structure connue d'un commutateur bistable de type repos-travail,
- la figure 2 illustre un commutateur bistable de type ouvert-fermé, mono-directionnel et pour courant continu,
- la figure 3 illustre un mode de réalisation d'un commutateur bistable de type ouvert-fermé, bidirectionnel et pour courant continu ou alternatif, selon l'invention,
- la figure 4 illustre un mode, de réalisation d'un commutateur bistable de type repos-travail, monodirectionnel et pour courant continu,
- la figure 5 illustre un mode de réalisation d'un commutateur bistable de type repos-travail, bidirectionnel et pour courant continu ou alternatif, selon l'invention,
- la figure 6 illustre un mode de réalisation d'un commutateur selon l'invention, dans lequel le moyen d'alimentation est composé d'un condensateur et d'un moyen de charge de ce condensateur,
- la figure 7 illustre une variante du commutateur de la figure 6 dans lequel le moyen de charge du condensateur est constitué par un convertisseur continu-continu, et
- les figures 8a et 8b représentent des commutateurs bidirectionnels respectivement de type ouvert-fermé et de type repos-travail, transformés en commutateurs bidirectionnels par l'adjonction de ponts de diodes.

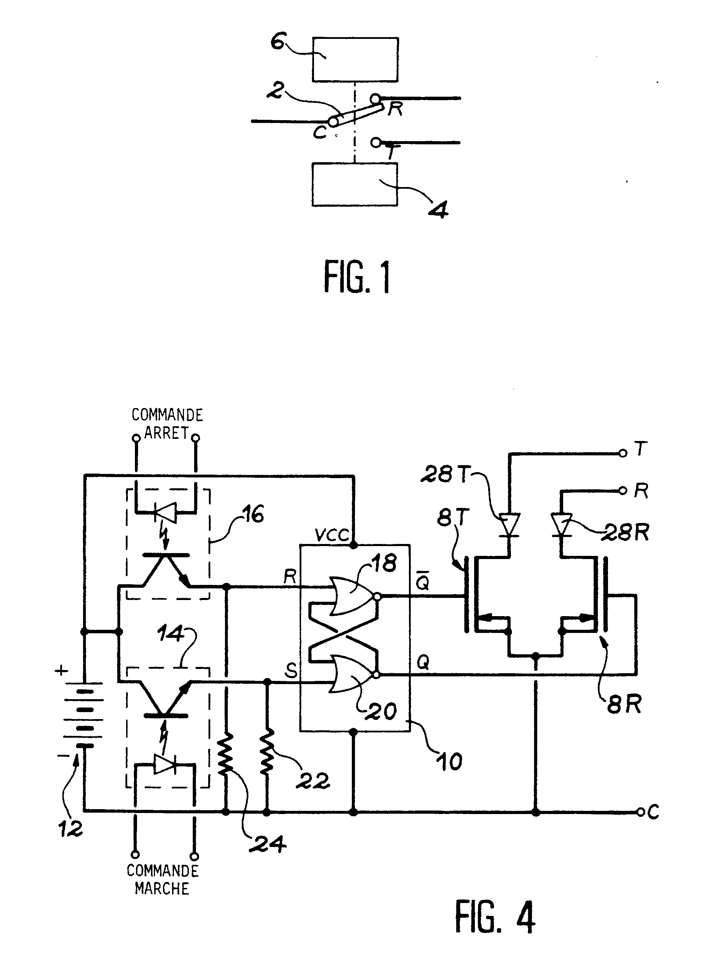

On a rappelé schématiquement sur la figure 1 la structure générale d'un commutateur bistable de type repos-travail. Ce commutateur comprend un interrupteur 2 muni d'une borne commune C, d'une borne de repos R et d'une borne de travail T, un circuit de commande 4 pour faire basculer l'interrupteur de la position de repos R à la position de travail T, et un circuit de commande 6 pour faire basculer l'interrupteur de la position de travail T à la position de repos R.

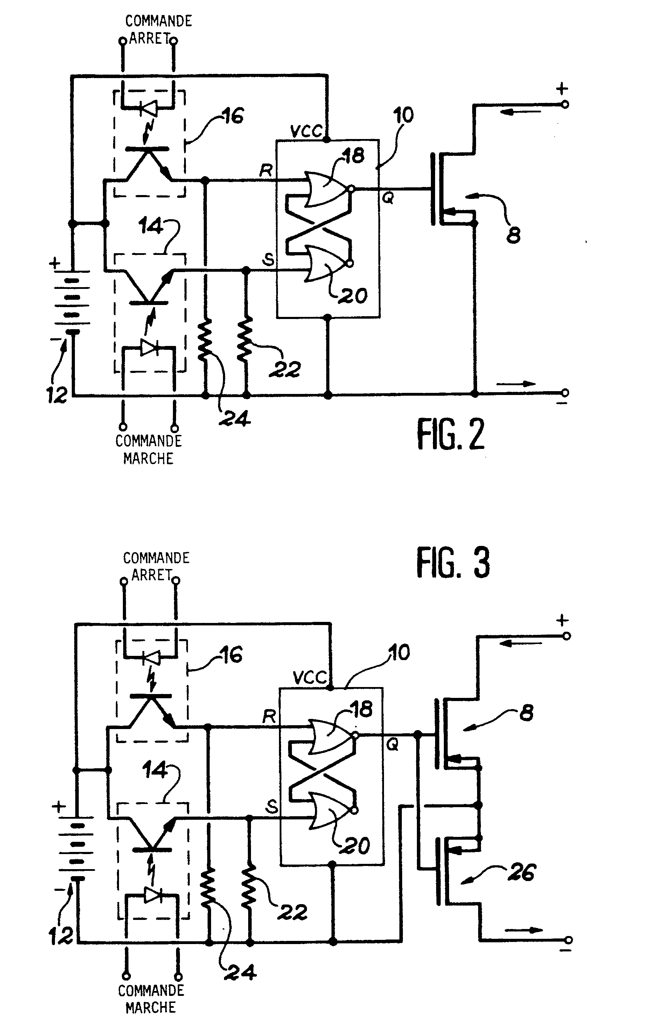

L'invention concerne les commutateurs bistables de type ouvert-fermé et de type repos-travail, bidirectionnel, continu et alternatif. On décrira d'abord en référence aux figures 2 à 4 différents modes de réalisation d'un commutateur de type ouvert-fermé.

On a représenté schématiquement sur la figure 2 un commutateur bistable de type ouvert-fermé, monodirectionnel continu. Ce commutateur se présente sous la forme d'un composant électronique. Il comprend un interrupteur constitué par un transistor MOS de puissance 8, un circuit de commande 10 pour commander le transistor 8, une source d'alimentation 12 du circuit de commande 10, et deux coupleurs optiques 14, 16 pour transmettre chacun un signal de commande de commutation, en assurant un isolement électrique entre le commutateur et le circuit émettant le signal de commande de commutation.

Les coupleurs optiques 14, 16 comprennent chacun une photodiode délivrant un signal optique correspondant à un signal électrique de commutation reçu, et un phototransistor commandé par ledit signal optique. Le collecteur du phototransistor est relié au pôle positif de la source d'alimentation 12 et l'émetteur du phototransistor est relié à une extrémité d'une résistance de charge 22, 24 dont l'autre extrémité est reliée au pôle négatif de la source d'alimentation.

Les bornes de l'interrupteur sont constituées par le drain et la source du transistor MOS 8. La résistance à l'état passant $R_{on}$ du transistor est très faible, ce qui permet de n'avoir qu'une une très faible chute de tension entre les bornes du commutateur.

Le circuit de commande 10 est de préférence un circuit MOS ou CMOS, de manière à avoir une faible consommation électrique. Dans ce cas, il est possible d'utiliser une pile de faible encombrement ayant une durée de vie supérieure à 10 ans et permettant un nombre de commutations supérieur à $5 \times 10^6$.

Il est composé d'une bascule bistable, qui peut être réalisée classiquement, comme représenté sur la figure, par un montage comprenant deux portes NON-OU 18, 20.

Ce circuit de commande permet de mémoriser un signal transmis par l'un des coupleurs optiques, et de maintenir ainsi l'état du transistor MOS 8 après que le signal de commutation appliqué sur le coupleur optique ait disparu.

Le commutateur représenté sur la figure 2 e est monodirectionnel. Il peut être complété de manière à constituer un commutateur bidirectionnel.

A titre d'exemple, on a représenté sur la figure 3 un commutateur bidirectionnel déduit du commutateur monodirectionnel représenté sur la figure 2. Le commutateur représenté sur la figure 3 comporte les mêmes éléments que le commutateur représenté sur la figure 2.

Il comprend en outre un deuxième transistor MOS de puissance 26 dont la source est reliée à la source du transistor MOS 8. Les grilles de ces transistors MOS sont réunies et reliées à la sortie du circuit de commande 10. Les drains des deux transistors MOS forment les bornes du commutateur.

Un signal traversant le commutateur subit une faible chute de tension. Pour un signal traversant le commutateur du transistor MOS 8 vers le transistor MOS 26, cette chute de tension est due en grande partie à la diode parasite du transistor MOS 26. Lorsque le signal va du transistor 26 vers le transistor MOS 8, la chute est identique et est due à la diode parasite du transistor MOS 8. Enfin, lorsque les deux transistors MOS sont ouverts, il reste aux bornes du commutateur deux diodes parasites en opposition ; le courant est alors bloqué dans les deux sens.

On a décrit en référence aux figures 2 et 3 des modes de réalisation d'un commutateur de type ouvert-fermé.

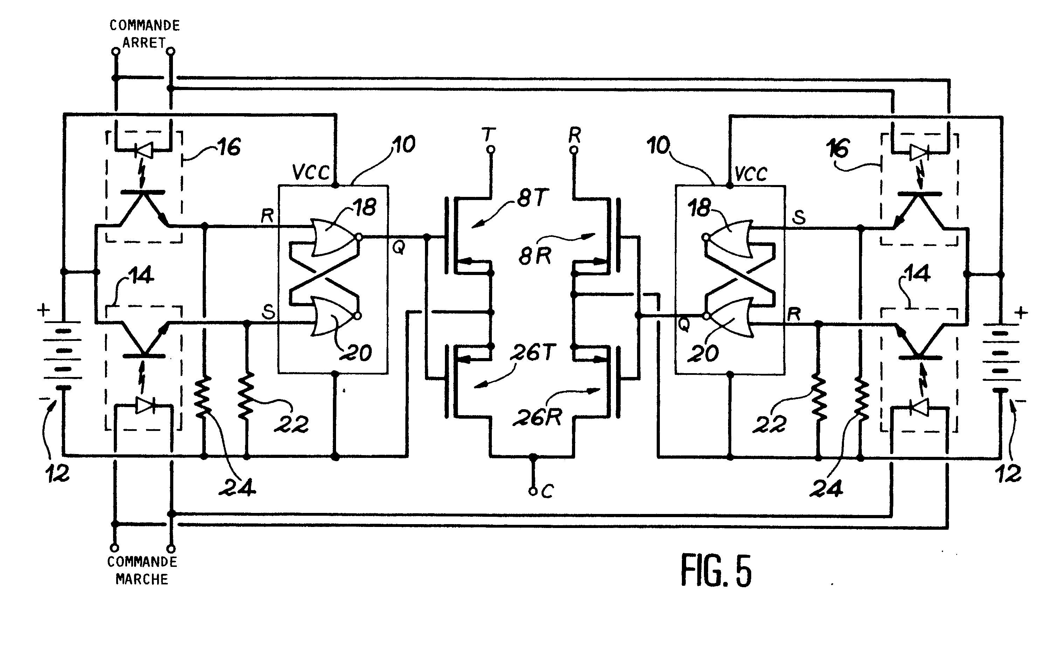

L'invention s'applique également aux commutateurs de type repos-travail. A titre d'exemple, on a représenté sur les figures 4 et 5 des modes de réalisation d'un tel commutateur.

Le commutateur bistable représenté sur la figure 4 est de type monodirectionnel et à courant continu. Il comprend deux transistors MOS de puissance 8R, 8T, un circuit de commande 10 desdits transistors MOS, une source d'alimentation 12 du circuit de commande, et deux coupleurs optiques 14, 16.

Les sources des transistors 8R, 8T sont reliées entre elles et constituent le point commun C de l'interrupteur. Des diodes 28R, 28T sont en outre prévues. Leurs cathodes sont reliées respectivement au drain des transistors 8R, 8T et leurs anodes constituent respectivement la borne de repos R et la borne de travail T de l'interrupteur.

Les grilles des transistors 8R, 8T reçoivent des signaux complémentaires délivrés par le circuit de commande 10. Celui-ci comprend deux entrées de commande R, S pour recevoir les signaux transmis par les coupleurs optiques 14, 16.

Les coupleurs optiques 14, 16 se composent d'une photodiode délivrant un signal optique correspondant à un signal électrique de commande de commutation reçu, et un phototransistor. Celui-ci est relié en série avec une résistance 22, 24 de forte valeur ; l'ensemble est relié aux bornes de la source d'alimentation 12.

Le circuit de commande 10 comprend une entrée R de remise à 0 et une entrée S de remise à 1, et deux sorties $\overline{Q}$, Q reliées respectivement aux grilles des transistors 8T et 8R et délivrant des signaux complémentaires.

Il est composé, par exemple, de deux portes NON-OU 18, 20 formant une bascule bistable identique au circuit de commande représenté sur la figure 3. La seule différence entre les deux circuits de commande est que les sorties de chacune des portes 18, 20 est utilisée dans le commutateur de la figure 4.

Le commutateur bistable de type repos-travail représenté sur la figure 4 est un commutateur monodirectionnel pour courant continu. Ce commutateur peut être modifié en commutateur bidirectionnel, suivant un principe de construction analogue à celui du commutateur de la figure 3, par rapport au commutateur de la figure 2.

Cette modification consiste à mettre deux ensembles en parallèle mais l'ordre "marche" de l'un est en parallèle avec l'ordre "arrêt" de l'autre et vice versa.

A titre d'exemple, on a représenté sur la figure 5 un commutateur bistable bidirectionnel déduit du commutateur de la figure 3.

Ce commutateur se compose de d eux parties essentiellement identiques, l'une correspondant à la fonction de travail et l'autre à la fonction de repos.

La partie réalisant la fonction de travail est identique au commutateur de la figure 3, les drains des transistors MOS 8T, 26T constituant respectivement la borne de travail T et la borne commune C du commutateur.

La partie réalisant la fonction de repos se déduit de la partie réalisant la fonction de travail par inversion des connexions des photocoupleurs 14, 16 sur les entrées R et S du moyen de commande 10. Ces photocoupleurs sont reliés en parallèle avec les photocoupleurs correspondant de la partie de travail.

Ainsi, une commande "arrêt" appliquée sur les photocoupleurs 16 de chaque partie active l'entrée R du circuit de commande 10 de la partie de travail et l'entrée S du circuit de commande 10 de la partie de repos, ce qui bloque les transistors 8T, 26T et rend passants les transistors 8R, 26R.

Inversement, une commande "marche" appliquée sur les photocoupleurs 16 de chaque partie active l'entrée S du circuit de commande 10 de la partie de travail et l'entrée R du circuit de commande 10 de la partie de repos, ce qui rend passants les transistors 8T, 26T et bloque les transistors 8R, 26R.

Les commutateurs représentés sur les figures 2 à 5 sont des commutateurs intégrés réalisés sous la forme d'un composant hybride. A titre d'exemple, les éléments suivants peuvent être utilisés pour réaliser les commutateurs représentés sur les figures 2 à 5 :

- coupleurs optiques 14, 16 de type TIL 155 de Texas Instrument ou HPCL 2503 de Hewlett Packard ou ISH 711 de Isocom,
- circuit de commande 10 en technologie CMOS composé de portes NON-OU, de type CD 4001 BCN de National Semiconductor ou MC 14001 UBAL ou MC 14001 BAL de Motorola
- transistors MOS de puissance de type IRF 050 ou IRF 150 de International Rectifier OU SMM 70N05 de Siliconix,
- source d'alimentation 12 composée de piles au lithium de type LM 2425 de Saft, ou de type 11620 de Catalyst Research Corporation, ou de type $\mu$ Powercell B35,
- résistances 22, 24 de 12 M$\Omega$.

Le commutateur bistable est ainsi obtenu sous la forme d'un composant hybride dont les dimensions peuvent être inférieures à 25×25×15mm, grâce à un choix et un arrangement judicieux des composants.

Les performances d'un commutateur conforme à l'invention dépendent essentiellement du choix du ou des transistors MOS de puissance utilisés comme interrupteur, et de la source d'alimentation du circuit de commande. Le transistor MOS de puissance doit être choisi en fonction de l'application, selon que l'on désire couper un signal de forte ou de faible tension, de forte ou de faible intensité. En ce qui concerne la source d'alimentation, une tension élevée entre ces bornes permet une faible chute de tension aux bornes de l'interrupteur pour des intensités élevées. Lorsque cette source d'alimentation est constituée de piles, sa capacité détermine la durée de vie et le nombre de commutations.

On a mesuré les performances à 25°C d'un commutateur pour courant continu conforme à l'invention. Pour un courant commuté I de 10A, un transistor MOS ayant une intensité d'écrêtage de 30A et une source d'alimentation constituée d'une pile de 6V, la chute de tension mesurée aux bornes du transistor MOS est de 0,65 V. Avec un transistor MOS ayant une intensité d'écrêtage de 160A et une source d'alimentation constituée d'une pile de 10V, la chute de tension mesurée est de 0,4V.

Pour un courant commuté important, et lorsque la chute de tension aux bornes du commutateur est un paramètre critique, il est possible de mettre plusieurs transistors MOS de puissance en parallèle.

Les autres caractéristiques du commutateur selon l'invention sont les suivantes :

- retard de commutation <30 $\mu$s
- temps de montée sur résistance $\leq$10 $\mu$s
- tension maximale aux bornes 100 V
- température de fonctionnement -55°C à + 125°C
- aucun axe sensible aux vibrations
- isolement entre commande et utilisation 3500 V crête
- courant de commande à partir de 5 mA
- durée minimum de la commande en bistable 0,5 $\mu$s
- large gamme de fonctionnement, de quelques millivolts et quelques microampères à quelques centaines de volts et jusqu'à 50 ampères, en fonction du transistor MOS de puissance.

La durée de vie d'un commutateur selon l'invention dépend de la source d'alimentation. Pour un commutateur bistable selon l'invention, utilisé à 25°C, la consommation permanente est de l'ordre de 2nA, la consommation lors d'une commutation est de 0,5 $\mu$A pendant le temps de commutation.

Une source d'alimentation constituée de piles de 200 mAH, et présentant une perte par vieillissement de 2% par an, permet ainsi de réaliser environ $10^9$ commutations sur une période de 10 ans, en ne consommant que la moitié de la capacité de la pile.

Pour une pile de 50 mAH présentant les mêmes caractéristiques de consommation et de vieillissement, le nombre de commutations est de l'ordre de 300x$10^6$.

Dans les commutateurs bistables selon l'invention représentés sur les figures 2 à 5, la source d'alimentation 12 du circuit de commande 10 est constituée des piles, ceci peut présenter, dans certaines applications, des inconvénients, notamment de volume. On peut y remédier en remplaçant les piles par un condensateur chargé sur une alimentation quelconque.

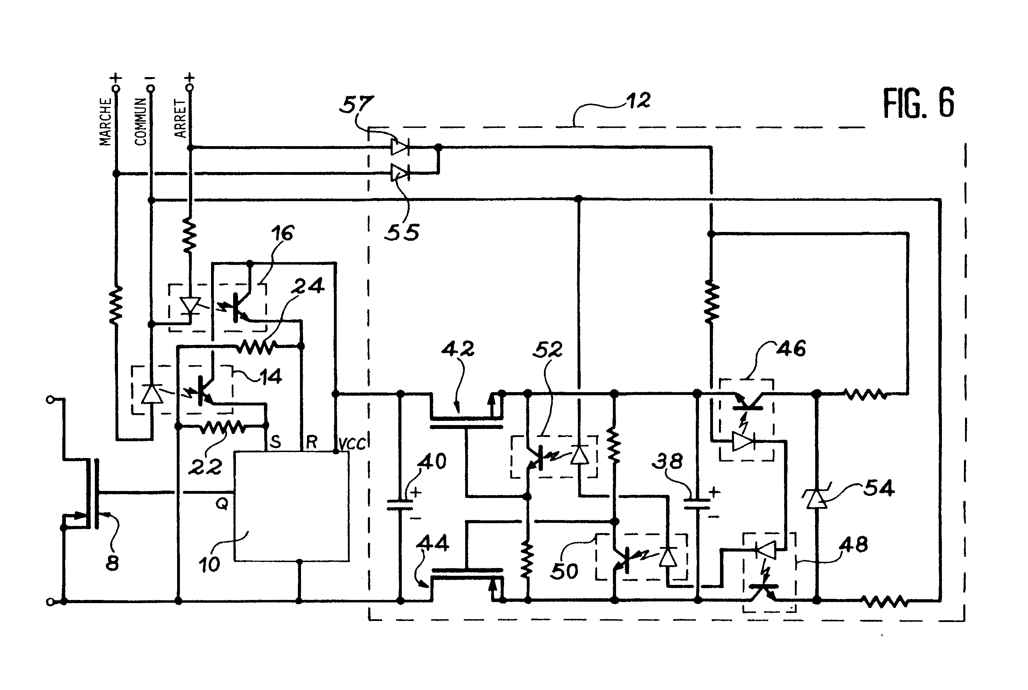

Un commutateur bistable selon l'invention dont la source d'alimentation 12 comprend un condensateur rechargeable est représenté sur la figure 6.

Ce commutateur bistable est de type monodirectionnel et pour courant continu dont tous les éléments, sauf la source d'alimentation 12, sont conformes à ceux du commutateur représenté sur la figure 2.

Dans le mode de réalisation de la figure 6, le moyen d'alimentation 12 comprend un condensateur principal 38 et un condensateur secondaire 40. Les extrémités du condensateur principal 38 sont chacune reliées aux bornes d'alimentation du circuit de commande 10 par l'intermédiaire d'un interrupteur, ces interrupteurs étant constitués respectivement par un transistor MOS de type P 42 et un transistor MOS de type N 44. Le condensateur supplémentaire 40 est relié directement aux bornes d'alimentation du circuit de commande 10.

Le moyen d'alimentation 12 comprend en outre 4 coupleurs optiques 46, 48, 50 et 52. Chaque coupleur optique comprend une photodiode et un phototransistor, les photodiodes des 4 coupleurs optiques étant disposées en série et reliées aux bornes de commande du commutateur de manière à être parcourues par un courant lorsque l'un des ordres d'arrêt ou de marche, c'est-à-dire d'ouverture ou de fermeture de l'interrupteur est reçu par le commutateur. Des diodes de protection 55, 57 sont prévues à cet effet sur les lignes recevant les ordres de marche et d'arrêt. La source d'alimentation 12 comprend enfin une diode Zener 54 qui fixe la tension de charge du condensateur principal 38.

Lorsque l'un des signaux de marche ou d'arrêt est transmis au commutateur, les phototransistors des coupleurs optiques 46 et 48 sont passants, ce qui met en parallèle la diode Zener 54 et le condensateur principal 38 ; ceci permet de charger le condensateur principal 38 à la tension de la diode Zener. Ce même signal de commande rend passant les transistors des coupleurs optiques 50 et 52 ce qui bloque les transistors MOS 42, 44 ; ceci permet d'isoler le circuit de commande 10.

Lorsque le signal de commande d'arrêt ou de marche disparaît, le condensateur principal 38 est isolé de la tension de charge et est mis en liaison avec le circuit de commande 10 et le condensateur supplémentaire 40. Ce dernier permet ainsi de continuer à alimenter le circuit de commande pendant une nouvelle charge du condensateur principal 38.

Avec un condensateur principal 38 ayant une capacité de 100 μF, le commutateur peut fonctionner pendant environ 1h30 avec un débit de 8A. L'expérience et le calcul montrent qu'un rafraîchissement toutes les heures est ainsi largement suffisant pour assurer le fonctionnement du commutateur.

La source d'alimentation représentée sur la figure 6 peut être réalisée, par exemple, au moyen des composants suivants :

- coupleurs optiques 46, 48, 50, 52 de type TIL 155 de Texas Instrument,
- condensateur principal 38 de 100 μF, 20 V,
- condensateur supplémentaire 40 de type 0,1 μF, 20 V,
- diode Zener 54 de 1W, 6,2 V de type BZX85C,
- transistor MOS 42 de type VQ2001 de Siliconix,
- transistor MOS 44 de type VQ1001 de Siliconix,
- diodes 55, 57 de type 1N 4148.

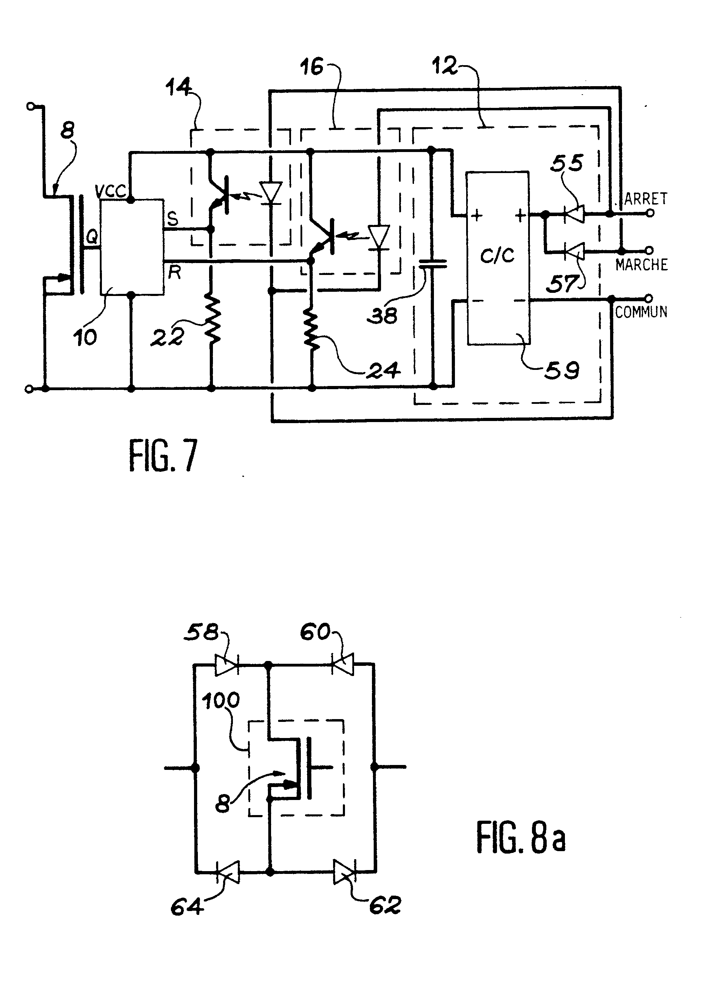

Selon une variante de réalisation, la source d'alimentation peut comprendre un condensateur principal 38 alimenté par un convertisseur continu-continu. Un commutateur bistable monodirectionnel et pour courant continu muni d'un tel moyen d'alimentation 12 est représenté sur la figure 7.

Le condensateur principal 38 du moyen d'alimentation 12 est relié directement aux bornes d'alimentation du circuit de commande 10. Ce condensateur est relié au secondaire d'un convertisseur continu-continu 59 dont le primaire reçoit les signaux de commande de marche ou d'arrêt du commutateur.

Le convertisseur continu-continu doit débiter au secondaire environ 2 mA, pour assurer un temps de charge convenable du condensateur 38. Le rachaîchissement est réalisé toutes les heures en repassant l'ordre (marche, arrêt) qui correspond à la position dans laquelle le commutateur doit être maintenu. Après une longue période de non-utilisation, le premier ordre de commutation doit être maintenu un peu plus longtemps. Le convertisseur continu-continu peut être du type V5R9 de Realibity.

On a décrit en référence aux figures 3 et 5 des commutateurs bistables bidirectionnels selon l'invention. Dans ces modes de réalisation, la bidirectionnalité était obtenue par l'utilisation de paires de transistors MOS de puissance dont les sources étaient reliées entre elles et dont les grilles étaient réunies. Un autre mode de réalisation consiste à disposer un commutateur bistable pour courant continu dans un pont de diodes.

Dans le cas d'un commutateur 100 de type ouvert-fermé, comme représenté sur la figure 8a, la bidirectionnalité est obtenue par l'adjonction d'un pont de diodes 58, 60, 62, 64 dont les points de potentiels haut et bas sont reliés respectivement à la source et au drain d'un transistor MOS de puissance 8 formant l'interrupteur du commutateur.

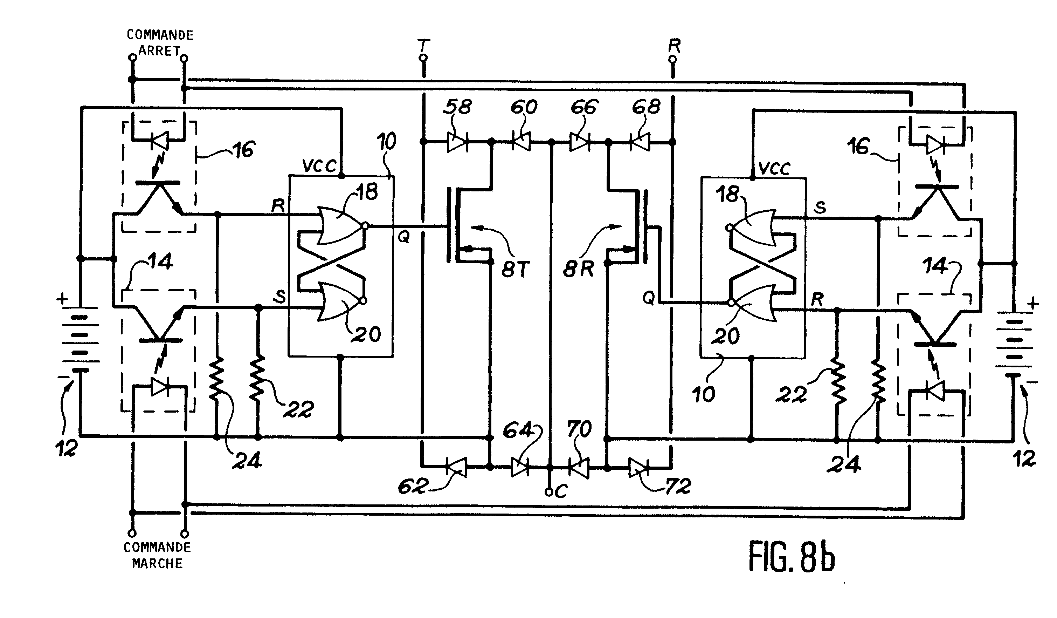

Un commutateur bistable bidirectionnel de type repos-travail est représenté sur la figure 8b. Ce commutateur se compose de deux parties essentiellement identiques, l'une correspondant à la fonction de travail et l'autre à la fonction de repos.

La partie réalisant la fonction de travail est identique au commutateur de la figure 2.

La partie réalisant la fonction de repos se déduit de la partie réalisant la fonction de travail par inversion des connexions des photocoupleurs 14, 16 sur les entrées R et S du moyen de commande 10. Ces photocoupleurs sont reliés en parallèle avec les photocoupleurs correspondants de la partie de travail.

Ainsi, une commande "arrêt" appliquée sur les photocoupleurs16 de chaque partie active l'entrée R du circuit de commande 10 de la partie de travail et l'entrée S du circuit de commande 10 de la partie de repos, ce qui bloque le transistor 8T et rend passant le transistor 8R.

Inversement, une commande "marche" appliquée sur les photocoupleurs 16 de chaque partie active l'entre S du circuit de commande 10 de la partie de travail et l'entrée R du circuit de commande 10 de la partie de repos, ce qui rend passant le transistor 8T et bloque le transistor 8R.

Pour chacune des deux parties, la bidirectionnalité est assurée par un pont de diodes : le transistor 8T est disposé dans un pont de diodes 58, 60, 62, 64, la source de ce transistor étant reliée au point de potentiel haut du pont de diodes et le drain au point de potentiel bas ; les deux autres extrémités du pont de diodes sont reliées à la borne de travail et à la borne commune du commutateur. De la même manière, le transistor 8R est disposé dans un pont de diodes 66, 68, 70, 72 dont les points de potentiel haut et bas sont reliés respectivement à la source et au drain du transistor 8R et dont les deux autres extrémités sont reliées à la borne de repos et à la borne commune du commutateur.

Les ponts de diodes permettent de transformer simplement un commutateur monodirectionnel en un commutateur bidirectionnel. Cependant, il faut noter que la chute de tension aux bornes du commutateur est plus importante pour les commutateurs représentés sur les figures 8a et 8b par rapport aux commutateurs représentés sur les figures 3 et 5, car le courant traverse deux diodes au lieu d'une seule. La chute de tension aux bornes des commutateurs bidirectionnels comprenant un pont de diodes est donc de l'ordre de 1,2 V.

**Revendications**

1. Commutateur électronique de puissance, bidirectionnel intégré comprenant un interrupteur muni d'au moins deux bornes, ledit interrupteur comportant deux transistors MOS de puissance (8, 26, 8T, 26T), les sources desdits transistors étant communes et les grilles réunies, les drains desdits transistors constituant les bornes de l'interrupteur, caractérisé en ce qu'il comprend, en outre :

   - un circuit de commande (10) en technologie MOS comprenant une bascule bistable munie d'une entrée de mise à "1" et d'une entrée de mise à "0" et d'une sortie de commande, chaque sortie de commande étant reliée aux grilles réunies des transistors MOS de puissance de l'interrupteur,
   - une source d'alimentation intégrée (12) pour alimenter ledit circuit de commande, et
   - deux coupleurs optiques (14, 16) pour assurer une bistabilité et recevoir chacun un signal électrique de commande de commutation et pour transmettre chacun ledit signal sur une entrée du circuit de commande, chaque coupleur optique assurant un isolement électrique du commutateur.

2. Commutateur de type repos-travail selon la revendication 1 , caractérisé en ce qu'il comprend deux coupleurs optiques (14, 16) pour transmettre respectivement un signal de commutation de l'interrupteur dans l'état ouvert et un signal de commutation de l'interrupteur dans l'état fermé, le circuit de commande (10) comprenant deux sorties complémentaires Q, $\overline{Q}$.

3. Commutateur de type repos-travail selon la revendication 1, caractérisé en ce qu'il comprend :

   - un interrupteur muni d'une borne de travail, d'une borne de repos et d'une borne commune, ledit interrupteur comprenant un premier ensemble de deux transistors MOS (8T, 26T) dont les sources sont communes et les grilles réunies, les drains desdits transistors MOS étant reliés respectivement à la borne de travail et à la borne commune de l'interrupteur, et un second ensemble de deux transistors MOS (8R, 26R) dont les sources sont communes et les grilles réunies, les drains desdits transistors MOS étant reliés respectivement à la borne de repos et à la borne commune de l'interrupteur,
   - pour chaque ensemble de transistors MOS : un circuit de commande (10) en technologie MOS comprenant une bascule bistable munie d'une entrée de mise à "1" et d'une entrée de mise à "0", et d'une sortie de commande, chaque sortie de commande étant reliée aux grilles desdits transistors MOS ; une source d'alimentation intégrée pour alimenter ledit circuit de commande ; et deux coupleurs optiques pour recevoir chacun un signal électrique de commande de commutation et pour transmettre ledit signal sur une entrée de commande du circuit de commande, chaque coupleur optique assurant un isolement électrique du commutateur, les circuits de commande associés aux deux transistors MOS recevant le même signal électrique de commande de commutation et délivrant des signaux de signes opposés sur les grilles des transistors MOS de chaque ensemble de transistors MOS.

4. Commutateur selon l'une quelconque des revendications 1 à 3, caractérisé en ce que la source d'alimentation (12) est formée de piles.

5. Commutateur selon l'une quelconque des revendications 1 à 3, caractérisé en ce que la source d'alimentation (12) comprend un condensateur (38) et un moyen de recharge dudit condensateur, ledit moyen de recharge étant alimenté par les signaux de commande de commutation transmis aux coupleurs optiques.

**Claims**

1. Integrated, bidirectional, electronic power commutator having a switch provided with at least two terminals, said switch having two MOS power transistors (8, 26, 8T, 26T), the sources of said transistors being common and the gates joined, the drains of said transistors constituting the terminals of the switch, characterized in that it also comprises a MOS technology control circuit (10) having a bistable flip-flop provided with an input for setting to 1 and an input for setting to 0 and a control output, each control output being connected to the joined gates of the MOS power transistors of the switch, an integrated power supply (12) for supplying the said control circuit and two optical couplers (14, 16) for ensuring a bistability and for in each case receiving an electric commutating control signal and for transmitting said signal to an input of the control circuit, each optical coupler ensuring an electrical insulation of the commutator.

2. Commutator of the rest-working type according to claim 1, characterized in that it comprises two optical couplers (14, 16) for respectively transmitting a switching signal from the switch in the open state and a switching signal from the switch in the closed state, the control circuit (10) having two complementary outputs Q, Q̄.

3. Commutator of the rest-working type according to claim 1, characterized in that it comprises a switch having a working terminal, a rest terminal and a common terminal, said switch having a first group of two MOS transistors (8T, 26T), whose sources are common and whose gates are joined, the drains of said MOS transistors being respectively connected to the working terminal and the common terminal of the switch, and a second group of two MOS transistors (8R, 26R), whose sources are common and gates joined, the drains of said MOS transistors being respectively connected to the rest terminal and the common terminal of the switch and for each group of MOS transistors: a MOS technology control circuit (10) having a bistable flip-flop provided with an input for setting to 1 and an input for setting to 0 and a control output, each control output being connected to the gates of said MOS transistors, an integrated power supply for supplying said control circuit and two optical couplers for in each case receiving an electric switching control signal and for transmitting said signal to a control input of the control circuit, each optical coupler ensuring an electrical insulation of the switch, the control circuits associated with the two MOS transistors receiving the same electric switching control signal and supplying two signals having opposite signs to the gates of the MOS transistors of each group of MOS transistors.

4. Commutator according to any one of the claims 1 to 3, characterized in that the power supply (12) is formed by batteries.

5. Commutator according to any one of the claims 1 to 3, characterized in that the power supply (12) comprises a capacitor (38) and a recharging means for said capacitor, said recharging means being supplied by switching control signals transmitted to the optical couplers.

**Patentansprüche**

1. Bistabiler, integrierter elektronischer Leistungsschalter mit einem Unterbrecher, der mit wenigstens zwei Anschlüssen versehen ist und der zwei MOS-Leistungstransistoren (8,26,8T,26T) enthält, deren Sources gemeinsam sind und deren Gates miteinander verbunden sind und deren Drains die Anschlüsse des Unterbrechers bilden, dadurch gekennzeichnet, daß er weiterhin enthält:

eine Steuerschaltung (10) in MOS-Technik, die eine bistabile Kippstufe enthält, die mit einem Setzeingang und einem Rücksetzeingang und einem Steuerausgang versehen ist, wobei jeder Steuerausgang mit den vereinigten Gates der MOS-Leistungstransistoren des Unterbrechers verbunden ist,

eine integrierte Versorungsquelle (12) zur Versorgung der Steuerschaltung, und

zwei Optukoppler (14,16) zur Erzeugung einer Bistabilität und zum Aufnehmen jeweils eines elektrischen Umschaltsteuersignals und jeweils zum Übertragen dieses Signals auf einen Eingang der Steuerschaltung, wobei jeder Optukoppler eine elektrische Isolation des Schalters bewirkt.

2. Schalter vom Ruhe-Arbeits-Typ nach Anspruch 1, dadurch gekennzeichnet, daß er zwei Optukoppler (14,16) enthält, um jeweils ein Signal zum Umschalten des Unterbrechers in den offenen Zustand und ein Signal zum Umschalten des Unterbrechers in den geschlossenen Zustand zu übertragen, wobei die Steuerschaltung (10) zwei komplementäre Ausgänge (Q,Q) enthält.

3. Schalter vom Ruhe-Arbeits-Typ nach Anspruch 1, dadurch gekennzeichnet, daß er enthält:

einen Unterbrecher, der mit einem Arbeitsanschluß, einem Ruheanschluß und einem gemeinsamen Anschluß versehen ist und der eine erste Gruppe aus zwei MOS-Transistoren (8T,26T) enthält, deren Sources gemeinsam und deren Gates verbunden sind, wobei die Drains der MOS-Transistoren jeweils mit dem Arbeitsanschluß und dem gemeinsamen Anschluß des Unterbrechers verbunden sind, und wobei der Unterbrecher weiterhin eine zweite Gruppe aus zwei MOS-Transistoren (8R,26R) enthält, deren Sources gemeinsam und deren Gates verbunden sind, wobei die Drains der genannten MOS-Transistoren jeweils mit dem Ruheanschluß und dem gemeinsamen Anschluß des Unterbrechers verbunden sind,

für jede MOS-Transistorgruppe: eine Steuerschaltung (10) in MOS-Technik, enthaltend eine bistabile Kippstufe mit einem Setzeingang, einem Rücksetzeingang und einem Steuerausgang, wobei jeder Steuerausgang mit den Gates der genannten MOS-Transistoren verbunden ist; eine integrierte Versorgungsquelle zur Versorgung der Steuerschaltung;

und zwei Optukoppler zum Aufnehmen jeweils eines elektrischen Schaltsteuersignals und zum Übertragen des Signals zum Steuereingang der Steuerschaltung, wobei jeder Optukoppler eine elektrische Isolierung des Schalters bewirkt, die den MOS-Transistoren zugeordneten Steuerschaltungen das gleiche elektrische Schaltsteuersignal empfangen und Signale mit entgegengesetzten Vorzeichen an die Gates der MOS-Transistoren jeder MOS-Transistorgruppe legen.

4. Schalter nach einem der Ansprüche 1 bis 3, dadurch gekennzeichnet, daß die Versorgungsquelle (12) von Batterien gebildet ist.

5. Schalter nach einem der Ansprüche 1 bis 3, dadurch gekennzeichnet, daß die Versorgungsquelle (12) einen Kondensator (38) und eine Ladeeinrichtung für den Kondensator enthält, wobei die Ladeeinrichtung von den Schaltsteuersignalen versorgt wird, die zu den Optukopplern übertragen werden.

## FIG. 1

## FIG. 4

FIG. 2

FIG. 3

FIG. 5

FIG. 6

MARCHE

COMMUN

ARRET

57

12

55

16

24

14

22

S    R   VCC

Q

10

8

42

52

40

44

50

38

46

54

48

EP 0 265 315 B1

14

**FIG. 7**

**FIG. 8a**

FIG. 8b